Europäisches Patentamt

European Patent Office

Office européen des brevets

(11) Publication number: **0 057 135**
**B1**

(12) **EUROPEAN PATENT SPECIFICATION**

(45) Date of publication of patent specification: **04.09.85**

(51) Int. Cl.⁴: **H 01 L 27/12, H 01 L 29/48**

(21) Application number: **82400107.7**

(22) Date of filing: **21.01.82**

(54) **Low resistance Schottky diode on polysilicon/metal-silicide.**

(30) Priority: **23.01.81 US 227837**

(43) Date of publication of application:
**04.08.82 Bulletin 82/31**

(45) Publication of the grant of the patent:
**04.09.85 Bulletin 85/36**

(84) Designated Contracting States:
**CH DE FR GB IT LI NL**

(56) References cited:
**GB-A-2 011 167**
**US-A-3 381 182**
**US-A-4 110 488**

**ELECTRONICS LETTERS, Vol. 15, No. 14 5 July 1979 Hitchin TASCH JUN. et al. "Silicon-on-insulator M.O.S.F.E.T.S Fabricated on Laser-Annealed Polysilicon on SiO2" pages 435 to 437**

(73) Proprietor: **FAIRCHILD CAMERA & INSTRUMENT CORPORATION**
**464 Ellis Street**
**Mountain View California 94042 (US)**

(72) Inventor: **Vora, Madhukar B.**
**110 Lansberry Court**
**Los Gatos California 95030 (US)**
Inventor: **Hingarh, Hemraj K.**
**3446 Woodyend Court**
**San Jose California 95121 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

(56) References cited:

**IEEE ELECTRON DEVICE LETTERS Vol. EDL-2, No. 7, July 1981 New York SHAH et al. "P-N Junction and Schottky Barrier Diode Fabrication in Laser Recrystallised Polysilicon on SiO2" pages 159 to 161**

# Description

## Background of the Invention

### 1. Field of the Invention

The present invention is directed to Schottky diodes and more particularly to a polysilicon Schottky diode which is fabricated by forming a sandwich of metal-silicide, polysilicon and metal on silicon dioxide.

### 2. Brief Description of Prior Art

Schottky diodes are commonly fabricated in single crystal silicon together with bipolar transistors. In such devices, an N+ buried layer is used as the diode cathode. This causes both diode series resistance and buried layer to substrate capacitance to be very high.

One example of a method of forming Schottky diodes in monocrystalline silicon is disclosed in U.S. patent US—A—4 110 488.

Schottky diodes have also been fabricated on polysilicon. However, two problems associated with this practice have been observed. First, Schottky diodes on polysilicon produce excessive leakage and low breakdown voltages. Second, such structures typically have high diode lateral series resistance due to the low mobility of electrons in polysilicon. An example of forming Schottky diodes in polysilicon is disclosed in U.K. patent G.B.—A—2 011 167.

## Summary of the Invention

A general object of the invention is to provide an improved Schottky diode and a method for manufacturing such a diode.

This and other objects are attained, in accordance with one aspect of the invention by a method for fabricating a Schottky diode according to claim 1.

Another aspect of the invention includes a Schottky diode structure according to claim 8.

In fabricating an integrated Schottky diode structure according to a preferred method of the present invention, a metal-silicide layer is deposited on an underlying layer of silicon dioxide. A polysilicon layer is then deposited on the upper surface of the metal-silicide layer. Phosphorous is then implanted into the polysilicon layer to provide a lower N+ polysilicon layer which forms an ohmic interface with the metal-silicide layer and a surface layer comprising N— polysilicon. The structure is then laser annealed such that about the top 3000 Angstroms of the polysilicon layer become single crystal. The polysilicon layer is then oxidized to form an overlying layer of silicon dioxide. The silicon dioxide is then masked and etched to create contact windows to expose selected underlying surface regions of the polysilicon layer. N+ impurities are then implanted near the surface of the polysilicon at one selected contact window to form an N+ region which serves as a metal-silicide pick-up. Finally, metal contacts are formed at the contact windows to create Schottky barrier anodes and a contact to the metal silicide pickup.

The Schottky barrier diode of the present invention provides the advantage over prior art structures of substantially eliminating capacitance problems. Moreover, if the polysilicon surface is laser annealed, the polysilicon is converted to single crystal which inhibits leakage and improves breakdown voltages. Finally, if the metal-silicide is utilized as a common cathode, lateral series resistance of the diode is reduced significantly.

## Description of a Preferred Embodiment

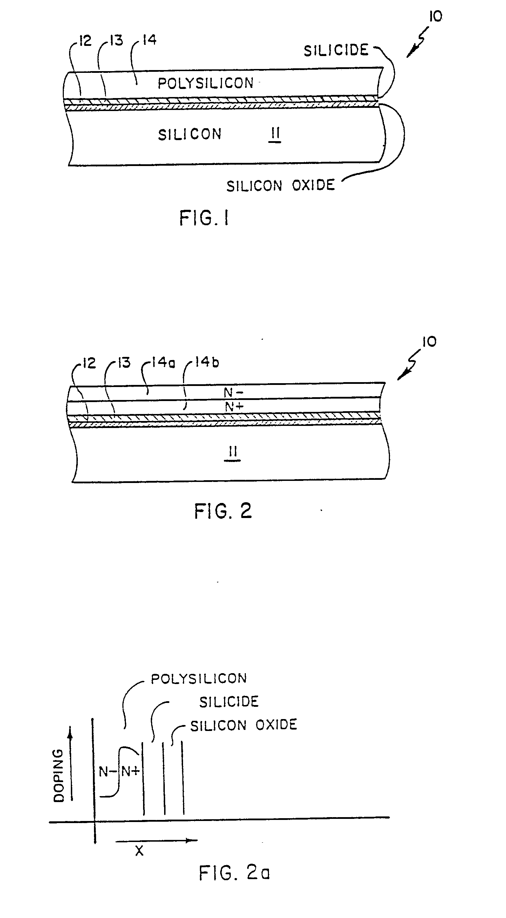

Fig. 1 shows a semiconductor wafer 10 which comprises a silicon dioxide layer 12 formed on the upper surface of an underlying silicon substrate 11. A layer of metal-silicide 13, preferably tantalum-silicide, preferably about 150 nm (1500 Angstroms) thick, is deposited upon the upper surface of the silicon dioxide layer 12 by either chemical vapor deposition or evaporation. A polysilicon layer 14, preferably about 500 nm (5000 Angstroms) thick, is deposited on the upper surface of the metal-silicide layer 13 by chemical vapor deposition.

As shown in Fig. 2, N-type impurities, typically phosphorous, are implanted in the polysilicon layer 14 to provide a lower N+ polysilicon layer 14b which forms an ohmic interface with the metal-silicide layer 13 and a surface layer 14a comprising N— polysilicon. A doping profile the polysilicon layer 14 is shown in Fig. 2a.

The upper surface of the wafer 10 is then laser annealed such that about the top 300 nm (3000 Anstroms) of the polysilicon layer 14 become single crystal. This is done to inhibit leakage between the metal anodes described below and the polysilicon layer. Then, using a photoresist mask (not shown), isolated islands of polysilicon/silicide are defined and oxidized to protect the sidewalls and the tops of the islands.

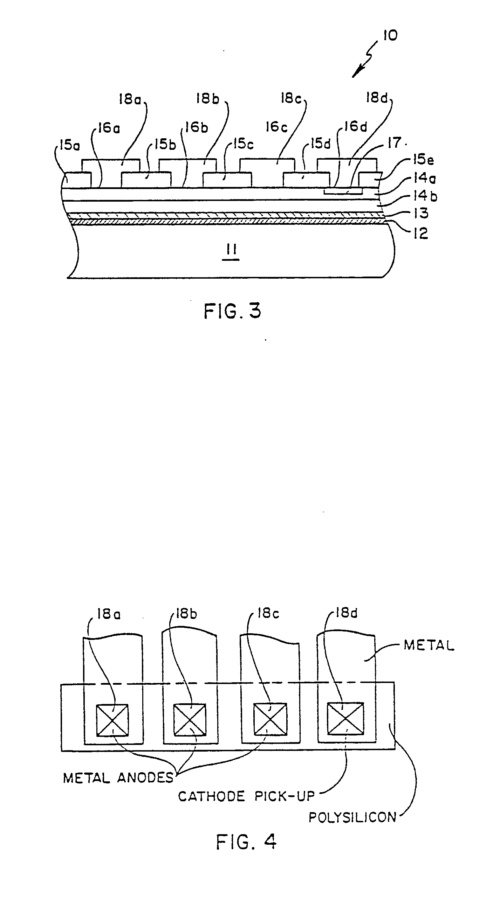

As shown in Fig. 3, the silicon dioxide layer which remains overlying the island is then masked and etched according to conventional photolithographic techniques to form regions 15a, 15b, 15c, 15d and 15e which define contact windows to exposed selected surface regions 16a, 16b, 16c and 16d of the polysilicon layer 14. N+ impurities are then implanted near the surface of the polysilicon layer 14 at one selected contact window to form an N+ region 17 which serves as a pick-up for the metal-silicide cathode. Metal, typically aluminum, is then deposited on the surface of the polysilicon layer 14 and defined by conventional techniques to form contacts at each contact window to create Schottky barrier anodes 18a, 18b, 18c and a contact 18d to the metal-silicide cathode.

Fig. 4 shows a topographical view of a completed Schottky diode island.

## Claims

1. A method for fabricating a Schottky diode, characterized by:

(a) forming a layer of metal-silicide (13) on an underlying layer of dielectric (12);

(b) forming a layer of polysilicon (14) on the upper surface of said metal-silicide layer, the polysilicon layer comprising a lower highly doped polysilicon layer (14b) forming an ohmic interface with the metal silicide layer and an upper (14a) relatively lightly doped polysilicon layer;

(c) forming a second dielectric layer (15a—15d) on the upper surface of said upper polysilicon layer and patterning said second dielectric layer to create a contact window through said second dielectric layer to an exposed surface region of said upper polysilicon layer; and

(d) forming a metal contact (18a—18c) to said exposed surface region to provide a Schottky barrier contact.

2. A method according to claim 1 characterized in that said metal-silicide is tantalum-silicide.

3. A method according to claim 1 or 2 characterized in that said dielectric is silicon dioxide.

4. A method according to claim 1, 2 or 3 characterized in that said polysilicon is N-type polysilicon.

5. A method according to claim 1, 2 or 3 for fabricating an integrated Schottky diode structure, characterized by: forming a plurality of contact windows through said second dielectric layer to a corresponding plurality of exposed surface regions of said polysilicon layer; forming a relatively heavily doped region (17) of the same conductivity type as said polysilicon layer in said polysilicon layer beneath one of said exposed surface regions; and in that said step of forming metal contacts produce metal contact (18d) to said relatively heavily doped region of said polysilicon layer to form a pick-up for said metal-silicide layer, said metal contacts (18a—18c) to said remaining surface regions of said polysilicon layer form Schottky anodes of said integrated Schottky diodes and said metal-silicide layer forms a common cathode of said Schottky diodes.

6. A method according to claim 5 characterized in that said polysilicon layer is doped to provide a lower N+ polysilicon layer which forms an ohmic interface with said metal-silicide layer and a surface layer comprising N− polysilicon.

7. A method according to claim 6 characterized in that said polysilicon layer is laser annealed such that about the top (3000 Angstroms) 300 nm of said polysilicon layer become single crystal.

8. A Schottky diode structure, comprising:

(a) a layer of metal-silicide (13) formed on an underlying layer of dielectric (12);

(b) a layer of polysilicon (14) formed on the upper surface of metal-silicide layer, the polysilicon layer comprising a lower (14b) highly doped polysilicon layer forming an ohmic interface with the metal-silicide layer and an upper (14a) relatively lightly doped polysilicon layer;

(c) a second dielectric layer (15a—15d) formed on the upper surface of said upper polysilicon layer and patterned such that a contact window extends through said second dielectric layer to a surface region of said upper polysilicon layer; and

(d) a metal contact (18a—18c) to said polysilicon surface region, said contact forming the Schottky anode of said Schottky diode structure and said metal-silicide forming the cathode of said structure.

9. A structure according to claim 8 characterized in that said metal-silicide is tantalum-silicide.

10. A structure according to claim 8 or 9 characterized in that said dielectric is silicon dioxide.

11. A structure according to claim 8, 9 or 10 characterized in that said polysilicon is N-type polysilicon.

12. A structure according to claim 8, 9 or 10 for an integrated Schottky diode characterized in that a plurality of said contact windows being formed through said second dielectric layer to a corresponding plurality of surface regions of said polysilicon layer;

a relatively heavily doped region (17) of the same conductivity type as said polysilicon layer being formed in said polysilicon layer beneath one of said surface regions; and

a plurality of said metal contacts to said exposed surface regions, said metal contact (18d) to said relatively heavily doped region of said polysilicon layer forming a pick-up for said metal-silicide layer, said metal contacts (18a—18c) to said remaining surface regions of said polysilicon layer forming Schottky anodes of said integrated diode structure and said metal-silicide layer forming a common cathode of said structure.

13. A structure according to claim 12 characterized in that said polysilicon layer is doped to provide a lower N+ polysilicon layer which forms an ohmic interface with said metal-silicide layer and a surface layer comprising N− polysilicon.

14. A structure according to claim 12 or 13 characterized in that said polysilicon layer has been laser annealed such that about the top 300 nm (3000 Angstroms) of said polysilicon layer is single crystal.

**Patentansprüche**

1. Ein Verfahren für die Herstellung einer Schottky-Diode, gekennzeichnet durch:

(a) Bilden einer Metallsilicidschicht (13) auf einer darunterliegenden Dielektriumsschicht (12),

(b) Bilden einer Polysiliciumschicht (14) auf der oberen Oberfläche der genannten Metallsilicidschicht, wobei die Polysiliciumschicht eine untere höher dotierte Polysiliciumschicht (14b) umfaßt, die eine Ohm'sche Grenzschicht mit der Metallsilicidschicht bildet und eine obere (14a) relativ leichtdotierte Polysiliciumschicht umfaßt,

(c) Bilden einer zweiten Dielektrikumsschicht (15a—15d) auf der oberen Oberfläche der genannten oberen Polysiliciumschicht und Musterbildung der genannten zweiten Dielektrikumsschicht zum Erzeugen eines Kontaktfensters durch die genannte zweite Dielektrikumsschicht zu einem freiliegenden Oberflächenbereich der genannten oberen Polysiliciumschicht und

(d) Bilden eines Metallkontakts (18a—18c) zu dem genannten freiliegenden Oberflächenbereich zwecks Ausbildung eines Schottky-Barriere-Kontakts.

2. Verfahren nach Anspruch 1, dadurch gekennzeichnet, daß das genannte Metallsilicid Tantalsilicid ist.

3. Verfahren nach Anspruch 1 oder 2, dadurch gekennzeichnet, daß das genannte Dielektrikum Siliciumdioxid ist.

4. Verfahren nach Anspruch 1, 2 oder 3, dadurch gekennzeichnet, daß das genannte Polysilicium N-Typ Polysilicium ist.

5. Verfahren nach Anspruch 1, 2 oder 3 zur Herstellung einer integrierten Schottky-Dioden-Struktur, gekennzeichnet durch: Ausbilden einer Mehrzahl von Kontaktfenstern durch die genannte zweite Dielektrikumsschicht zu einer entsprechenden Mehrzahl von freiliegenden Oberflächenbereichen der genannten Polysiliciumschicht; Ausbilden eines relativ hochdotierten Bereiches (17) desselben Leitfähigkeitstyps wie die genannte Polysiliciumschicht in der genannten Polysiliciumschicht unter einem der genannten freiliegenden Oberflächenbereiche und dadurch, daß der genannte Schritt der Ausbildung des Metallkontakts die Erzeugung eines Metallkontakts (18d) mit dem genannten relativ hochdotierten Bereich der genannten Polysiliciumschicht umfaßt zur Ausbildung eines Abgriffs für die genannte Metallsiliciumschicht, wobei die genannten Metallkontakte (18a—18d) zu den verbleibenden Oberflächenbereichen der genannten Polysiliciumschicht Schottky-Anoden der genannten integrierten Schottky-Dioden bilden und die genannte Metallsilicidschicht eine gemeinsame Kathode der genannten Schottky-Dioden bildet.

6. Verfahren nach Anspruch 5, dadurch gekennzeichnet, daß die Polysiliciumschicht dotiert ist zum Ausbilden einer unteren N+ Polysiliciumschicht, die eine Ohm'sche Grenzfläche mit der genannten Metallsilicidschicht bildet, und einer Oberflächenschicht mit N− Polysilicium.

7. Verfahren nach Anspruch 6, dadurch gekennzeichnet, daß die genannte Polysiliciumschicht lasergehärtet ist, derart, daß etwa die oberen (3000 Ångström) 300 Nanometer der genannten Polysiliciumschicht Einkristall werden.

8. Schottky-Diodenstruktur, umfassend:

(a) eine Schicht von Metallsilicid (13), ausgebildet auf einer darunter gebildeten Dielektriumsschicht (12);

(b) eine Polysiliciumschicht (14) gebildet auf der oberen Oberfläche der Metallsilicidschicht, wobei die Polysiliciumschicht eine untere (14b) hochdotierte Polysiliciumschicht umfaßt zur Ausbildung einer Ohm'schen Grenzfläche mit Metallsilicidschicht sowie eine obere (14a) relativ leichtdotierte Polysiliciumschicht;

(c) eine zweite Dielektrikumsschicht (15a—15d), ausgebildet auf der oberen Oberfläche der genannten oberen Polysiliciumschicht und musterbearbeitet derart, daß ein Kontaktfenster sich durch die genannte zweite Dielektrikumsschicht erstreckt zu einem Oberflächenbereich der genannten oberen Polysiliciumschicht; und

(d) einen Metallkontakt (18a—18c) zu dem genannten Polysiliciumoberflächenbereich, welcher Kontakt die Schottky-Anode der genannten Schottky-Diodenstruktur bildet, während das genannte Metallsilicid die Kathode dieser genannten Struktur bildet.

9. Struktur nach Anspruch 8, dadurch gekennzeichnet, daß das genannte Metallsilicid Tantalsilicid ist.

10. Struktur nach Anspruch 8 oder 9, dadurch gekennzeichnet, daß das genannte Dielektrikum Siliciumdioxid ist.

11. Struktur nach Anspruch 8, 9 oder 10, dadurch gekennzeichnet, daß das genannte Polysilicium vom N-Typ ist.

12. Struktur nach Anspruch 8, 9 oder 10 für eine integrierte Schottky-Diode, dadurch gekennzeichnet, daß eine Mehrzahl der genannten Kontaktfenster durch die genannte zweite Dielektrikumsschicht ausgebildet wird zu einer entsprechenden Mehrzahl von Oberflächenbereichen der genannten Polysiliciumschicht,

ein relativ hochdotierter Bereich (17) desselben Leitfähigkeitstyps wie die genannte Polysiliciumschicht in der Polysiliciumschicht unter einem der genannten Oberflächenbereiche gebildet wird, und

eine Mehrzahl der genannten Metalkontakte zu den genannten freiliegenden Oberflächenbereichen gebildet wird, wobei der genannte Metallkontakt (18d) zu dem genannten relativ hochdotierten Bereich der genannten Polysiliciumschicht einen Abgriff bildet für die genannte Metallsilicidschicht, wobei die Metallkontakte (18a—18c) zu den genannten verbleibenden Oberflächenbereichen der genannten Polysiliciumschicht Schottky-Anoden der genannten integrierten Diodenstruktur bilden, und die genannte Metallsilicidschicht eine gemeinsame Kathode der genannten Struktur bildet.

13. Struktur nach Anspruch 12, dadurch gekennzeichnet, daß die genannte Polysiliciumschicht dotiert ist zum Ausbilden einer unteren N+ Polysiliciumschicht, die eine Ohm'sche Grenzfläche mit der genannten Metallsilicidschicht bildet, und eine Oberflächenschicht mit N− Polysilicium.

14. Struktur nach Anspruch 12 oder 13, dadurch gekennzeichnet, daß die genannte Polysiliciumschicht lasergehärtet ist, derart, daß etwa die oberen 300 nm (3000 Ångström) der genannten Polysiliciumschicht ein Einkristall sind.

**Revendications**

1. Procédé de fabrication d'une diode Schottky caractérisé par les étapes suivantes:

(a) former une couche de siliciure de métal (13) sur une couche sous-jacente de diélectrique (12);

(b) former une couche de polysilicium (14) sur la surface supérieure de ladite couche de siliciure de métal, la couche de polysilicium comprenant une couche inférieure (14b) de polysilicium fortement dopé formant une interface ohmique avec la couche de siliciure de métal et une couche supérieure (14a) de polysilicium relativement faiblement dopé;

(c) former une deuxième couche de diélectrique (15a—15d) sur la surface supérieure de ladite couche supérieure de polysilicium et découper ladite deuxième couche de diélectrique pour créer une fenêtre de contact, au travers de ladite deuxième couche de diélectrique jusqu'à une région exposée de surface de ladite couche supérieure de polysilicium; et

(d) former un contact métallique (18a—18c) sur ladite région exposée de surface pour réaliser un contact de barrière Schottky.

2. Procédé selon la revendication 1, caractérisé en ce que ledit siliciure de métal est du siliciure de tantale.

3. Procédé selon la revendication 1 ou 2, caractérisé en ce que ledit diélectrique est du dioxyde de silicium.

4. Procédé selon la revendication 1, 2 ou 3, caractérisé en ce que ledit polysilicium est du polysilicium de type N.

5. Procédé selon la revendication 1, 2 ou 3, pour fabriquer une structure de diodes intégrées Schottky, caractérisé par les étapes suivantes: former une pluralité de fenêtres de contact, au travers de ladite deuxième couche de diélectrique, jusqu'à une pluralité correspondante de régions exposées de surface de ladite couche de polysilicium; former une région (17) relativement fortement dopée du même type de conductivité que ladite couche de polysilicium, dans ladite couche de polysilicium en dessous d'une desdites régions exposées de surface; et caractérisé en ce que ladite étape consistant à former des contacts métalliques réalise un contact métallique (18d) — sur ladite région relativement fortement dopée de ladite couche de polysilicium pour former une connexion à ladite couche de siliciure de métal, lesdits contacts métalliques (18a—18c) sur lesdites régions restantes de surface de ladite couche de polysilicium forment les anodes Schottky desdites diodes intégrées Schottky et ladite couche de siliciure de métal forme une cathode commune desdites diodes Schottky.

6. Procédé selon la revendication 5, caractérisé en ce que ladite couche de polysilicium est dopée pour réaliser une couche inférieure de polysilicium N+ qui forme une interface ohmique avec ladite couche de siliciure de métal et une couche de surface constituée de polysilicium N−.

7. Procédé selon la revendication 6, caractérisé en ce que ladite couche de polysilicium est recuite au laser de façon qu'approximativement les 300 nm (3000 angströms) supérieurs de ladite couche de polysilicium deviennent un cristal unique.

8. Structure de diode Schottky comprenant:
(a) une couche (13) de siliciure de métal formée sur une couche sous-jacente de diélectrique (12);
(b) une couche de polysilicium (14) formée sur la surface supérieure de la couche de siliciure de métal, la couche de polysilicium comprenant une couche inférieure (14b) de polysilicium fortement dopé formant une interface ohmique avec la couche de siliciure de métal et une couche supérieure (14a) de polysilicium relativement faiblement dopé;

(c) une deuxième couche de diélectrique (15a—15d) formée sur la surface supérieure de ladite couche supérieure de polysilicium et découpée de façon qu'une fenêtre de contact traverse ladite deuxième couche de diélectrique jusqu'à une région de surface de ladite couche supérieure de polysilicium; et

(d) un contact métallique (18a—18c) sur ladite région de surface du polysilicium, ledit contact constituant l'anode Schottky de ladite structure de diode Schottky et ledit siliciure de métal formant la cathode de ladite structure.

9. Structure selon la revendication 8, caractérisée en ce que ledit siliciure de métal est du siliciure de tantale.

10. Structure selon la revendication 8 ou 9, caractérisée en ce que ledit diélectrique est du dioxyde de silicium.

11. Structure selon la revendication 8, 9 ou 10, caractérisée en ce que ledit polysilicium est du polysilicium de type N.

12. Structure selon la revendication 8, 9 ou 10 pour une diode Schottky intégrée, caractérisée en ce qu'elle comprend une pluralité desdites fenêtres de contact formées au travers de ladite deuxième couche de diélectrique jusqu'à une pluralité correspondante de régions de surface de ladite couche de polysilicium;

une région (17) relativement fortement dopée, du même type de conductivité que ladite couche de polysilicium, formée sur ladite couche de polysilicium sous l'une desdites régions de surface; et

une pluralité desdits contacts métalliques formés sur lesdites régions de surface exposées, ledit contact métallique (18d) sur ladite région fortement dopée de ladite couche de polysilicium formant une connexion à ladite couche de siliciure de métal, lesdits contacts métalliques (18a—18c) sur lesdites régions de surface restantes de ladite couche de polysilicium formant les anodes Schottky de ladite structure de diodes intégrées et ladite couche de siliciure de métal formant une cathode commune de ladite structure.

13. Structure selon la revendication 12, caractérisée en ce que ladite couche de polysilicium est dopée pour constituer une couche inférieure de polysilicium N+ qui forme une interface ohmique entre ladite couche de siliciure de métal et une couche de surface constituée de polysilicium N−.

14. Structure selon la revendication 12 ou 13, caractérisée en ce que ladite couche de polysilicium est recuite au laser de façon qu'environ les 300 nm (3000 angströms) supérieurs de ladite couche de polysilicium soient un cristal unique.

FIG. 1

FIG. 2

FIG. 2a

1

10

18a    18b    18c    18d

16a    16b    16c    16d

15a    15b    15c    15d    17    15e

14a

14b

13

12

11

## FIG. 3

18a    18b    18c    18d

METAL

METAL ANODES

CATHODE PICK-UP

POLYSILICON

## FIG. 4